Europäisches Patentamt

European Patent Office

Office européen des brevets

(11) Publication number: **0 424 911 A2**

# EUROPEAN PATENT APPLICATION

(21) Application number: 90120409.9

(51) Int. Cl.5: **G11C 29/00**

(22) Date of filing: 24.10.90

(30) Priority: 25.10.89 JP 276040/89

(43) Date of publication of application:
02.05.91 Bulletin 91/18

(84) Designated Contracting States:
DE FR GB

(71) Applicant: **Kabushiki Kaisha Toshiba**
**72, Horikawa-cho Saiwai-ku**
**Kawasaki-shi(JP)**

(72) Inventor: **Inoue, Akifumi, c/o Intellectual**
**Property Div.**
**K. K. Toshiba, 1-1 Shibaura 1-chome,**
**Minato-ku**
**Tokyo 105(JP)**

(74) Representative: **Henkel, Feiler, Hänzel &**
**Partner**
**Möhlstrasse 37**
**W-8000 München 80(DE)**

(54) Memory system having self-testing function.

(57) A one-chip LSI includes a memory cell (5) for storing data and a test circuit (1 - 4, 6 - 17), connected to the memory cell (5), for performing a test for the memory cell (5) and outputting the test result. The test circuit includes a plurality of operation modes and executes a test in response to mode data supplied from a CPU in accordance with one of the plurality of operation modes.

FIG. 1

## MEMORY SYSTEM HAVING SELF-TESTING FUNCTION

The present invention relates to a memory chip having a circuit for testing a memory cell and to a data processing system using the memory chip.

In a computer, a main memory is a very important part for storing an operating system (OS), programs, and data. Therefore, before a computer is used, its main memory must be tested to confirm whether the main memory is free from any failure.

A test for a main memory is performed by a CPU as in normal memory access. Therefore, in a conventional computer, the test for the main memory disadvantageously takes a lot of time.

In the field of personal computers, a backup function has been utilized. It supplies a power to a main memory even when a main power source is in an OFF state. However, it is not checked whether memory data of the main memory is accurately maintained when the main memory is turned on again, since the check requires a lot of time. For this reason, when part of the memory data of the memory is broken during an OFF state, the personal computer may erroneously be operated when it is driven again.

The present invention has been made in consideration of the above situation, and has as its object to provide a memory chip having a test circuit.

It is another object of the present invention to provide a memory chip which can check a memory cell by itself.

It is still another object of the present invention to provide a data processing system capable of easily checking a memory at a high speed.

It is still another object of the present invention to provide a data processing system capable of easily checking a backed-uped memory at a high speed.

In order to achieve the above objects, a memory chip according to the first aspect of the present invention comprises memory means for storing data and instruction, address buffer means in which an address of the memory means is set, output buffer means in which data read out from the memory means is set, input buffer means in which write data to the memory means is set, test information generating means for generating a test address and test data for testing the memory means on a basis of external mode data and supplying the test address and the test data to the address buffer means and the input buffer means, addressing means for receiving the test address supplied from the test information generating means through the address buffer means and addressing the memory means, writing means for receiving the test data supplied from said test information generating means through said input buffer means and writing said test data in locations of said memory means designated by said addressing means, and checking means for reading out said test data from said memory means, and checking whether said memory means being capable of operating correctly.

With the above arrangement, the memory chip of the present invention can check a memory cell by itself. Therefore, the memory cell can be tested within a short time compared with a prior art in which a memory cell is checked by a CPU. In addition, when a large number of memory chips are used, since a memory test can be parallelly performed, the test is performed within a short time.

In order to achieve the above objects, a data processing system according to the second aspect of the present invention, comprising power source means for designating an ON/OFF state of a main power source of the data processing system, memory means, having a self-testing function, for storing data and instruction, the memory means including memory cell means for storing data and test means, connected to the memory cell means, for testing the memory cell means and out-putting a test result, and processing means for processing data using the memory means in accordance with a predetermined program when the main power source is set in an ON state, wherein the processing means supplies an instruction to the test means to cause the test means to perform a test for the memory cell means, after the test performed by the test means is ended, receives a test result, and performs data processing on the basis of the test result.

With the above arrangement, in a data processing system according to the present invention, a memory chip can check its memory cell by itself. Therefore, the memory cell can be tested within a short time compared with a prior art in which a memory cell is checked by a CPU. In addition, when a large number of memory chips are used, since a memory test can be parallelly performed, the test is performed within a short time.

This invention can be more fully understood from the following detailed description when taken in conjunction with the accompanying drawings, in which:

Fig. 1 is a block diagram showing an arrangement of a memory chip according to an embodiment of the present invention;

Fig. 2 is a block diagram showing an arrangement of a data processing system using the memory chip in Fig. 1 as a main memory;

Fig. 3 is a flow chart for explaining an operation of the system in Fig. 2;

Fig. 4 is a block diagram showing a modification of the system in Fig. 2; and

Figs. 5A to 5C and 6A to 6N are timing charts for explaining operations of the circuits in Figs. 1 and 2 in detail.

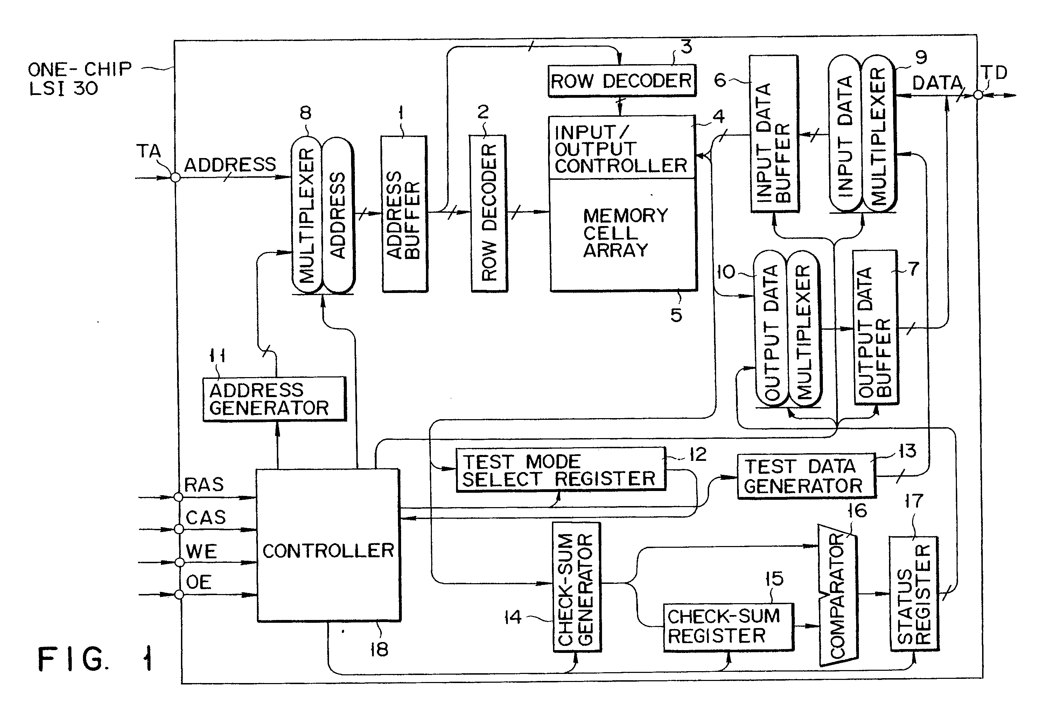

An embodiment of the present invention will be described below with reference to the accompanying drawings. Fig. 1 is a block diagram showing a one-chip memory LSI according to the embodiment of the present invention.

Referring to Fig. 1, an address buffer 1 buffers row and column addresses supplied from an address multiplexer 8. A row decoder 2 latches the row address supplied from the address buffer 1. The row decoder 2 decodes the latched row address and drives a row line (not shown) in a memory cell array 5 on the basis of the decoding result. A column decoder 3 latches the column address supplied from the address buffer 1. The column decoder 3 decodes the latched column address and drives a bit line (not shown) in the memory cell array 5 on the basis of the decoding result. The row decoder 2, in response to an address data from an address generator 11, has a function of setting row lines in a selection state sequentially.

An input/output controller 4 includes a sense amplifier and amplifies and outputs data read from the memory cell array 5. The input/output controller 4 controls data input to the memory cell array 5.

The memory cell array 5 consists of a Dynamic Random Access Memory (DRAM) and includes the row and bit lines and memory cells arranged in a matrix form.

An input buffer 6 supplies input data supplied from an input multiplexer 9 to the input/output controller 4. The output buffer 7 buffers data supplied from the input/output controller 4 through an output multiplexer 10. The output buffer 7 outputs the data to the outside of the memory chip through a data terminal TD.

An address multiplexer 8 selects one of addresses externally supplied through an address terminal TA and generated by an address generator 11 and supplies it to the address buffer 1. The input multiplexer 9 selects one of data externally supplied through a data terminal TD and generated by a test data generator 13 and supplies it to the input buffer 6. The output multiplexer 10 selects one of data read out from the memory cell array 5 through the input/output controller 4 and held by a status register 17 and supplies it to the output buffer 7.

The address generator 11 generates an address for testing the memory cell array 5 and an address for refreshing the memory cell array 5 and supplies them to the address multiplexer 8.

A mode select register 12 holds mode data externally supplied through the data terminal TD, the input data multiplexer 9, and the input buffer 6. One of a plurality of test modes is set (selected) according to the value of the mode data.

A test data generator 13 generates data for testing and clearing the memory cell array 5 and supplies it to the input data buffer 6 through the input data multiplexer 9.

A check-sum generator 14 generates a check-sum of the data supplied from the memory cell array 5 or the input data buffer 6. A check-sum register 15 holds the check-sum generated by the check-sum generator 14. A comparator 16 compares the check-sum held by the register 15 with a check-sum newly generated by the check-sum generator 14. A status register 17 holds the comparison result obtained by the comparator 16. In addition, a flag indicating the end of the test is set in the status register 17 by the controller 18.

The controller 18 generates control signals for controlling operations and operation timings of parts shown in Fig. 1 in response to external memory control signals (RAS (row address strobe), CAS (column address strobe), WE (write enable), and OE (output enable)).

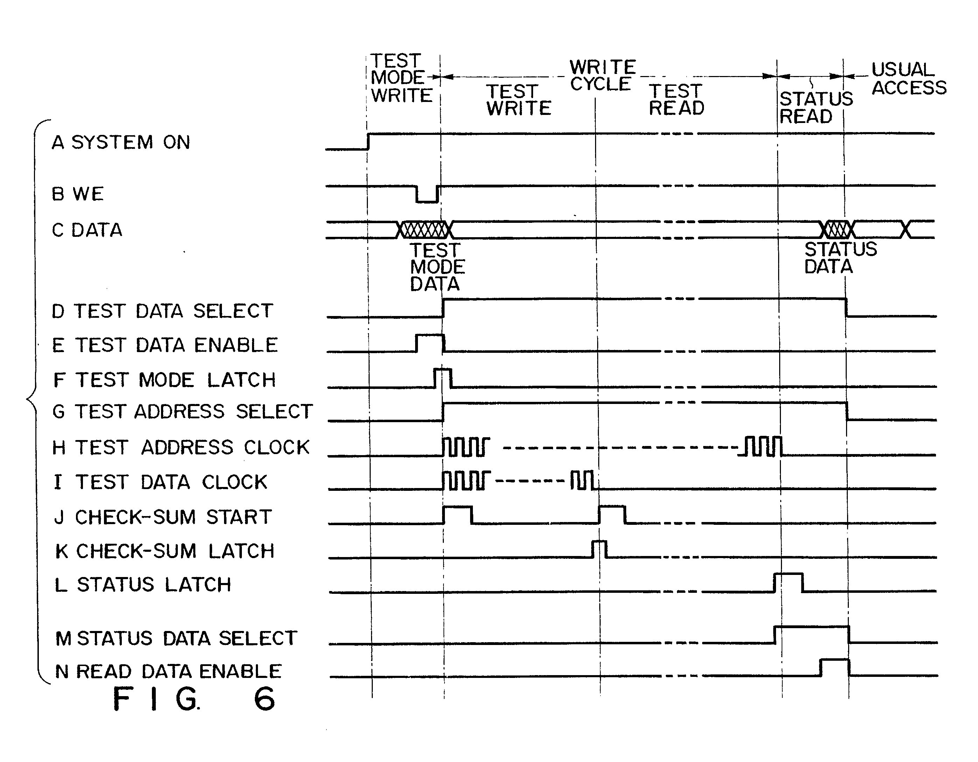

By using these control signals, the controller 18 controls operations and operation timings of the buffers 6, and 7; the multiplexers 8, 9, and 10; the address generator 11; the registers 12, 15, and 17; the test data generator 13; the check-sum generator 14; and the status register 17. The operation of the controller 18 will be described later with reference to Figs. 5A to 6N.

A backup voltage VB are applied to each circuit in the memory chip regardless of the ON/OFF of a main power.

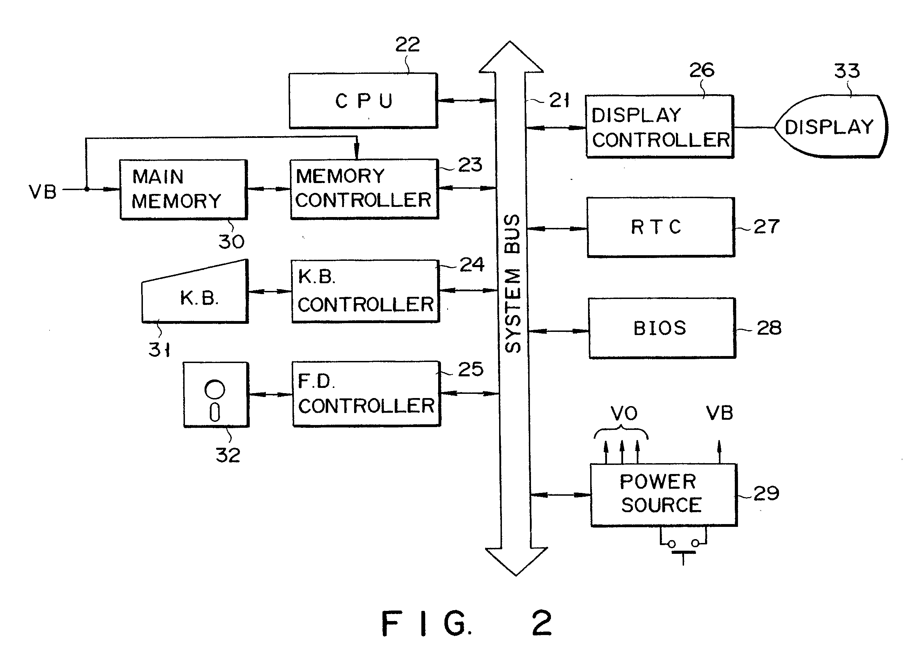

An arrangement of a data processing system using a one-chip memory LSI in Fig. 1 as a main memory will be described below with reference to Fig. 2.

Referring to Fig. 2, a CPU 22, a memory controller 23, a keyboard controller 24, a floppy disk controller 25, a display controller 26, a real timer controller (RTC) 27, a BIOSROM 28, and a power source circuit 29 are connected to a system bus 21. A main memory 30 has a structure shown in Fig. 1. A keyboard 31 is connected to the keyboard controller 24. A floppy disk unit 32 is connected to the floppy disk controller 25. A display monitor 33 is connected to the display controller 26.

The system bus 21 includes a control bus, a data bus, and an address bus and transmits a control signal, data, an address, and the like. The CPU 22 is operated in accordance with programs and data stored in the main memory 30, the BIOSROM 28, and the like to perform control of the whole system and data processing.

The memory controller 23 is controlled by the CPU 22 to write data in the main memory 30 and to read out the data from the main memory 30. As shown in Figs. 5A and 5B, when the operation voltage VO is applied from the power source circuit 29 to the memory controller 23 (the system power is ON), the RAS signal is supplied to the main memory 30 every interval of 15 $\mu$s to refresh the memory cell array 5. When the operation voltage VO is applied from the power source circuit 29 to the memory controller 23 the memory controller 23 supplies the RAS signal to the main memory 30 every interval of 90 $\mu$s to refresh the memory cell array 5.

The main memory 30 having an arrangement shown in Fig. 1 is controlled by the memory cell controller 23 to store an OS, a program, data, and the like.

The keyboard controller 24 controls the keyboard 31. The floppy disk controller 25 controls the floppy disk unit 32. The display controller 26 controls the display unit 33. The RTC 27 comprises an exclusive power source and a timer for measuring a current time. In addition, the RTC 27 comprises a memory for storing a flag indicating an ON/OFF state of a resume mode. The BIOSROM 28 stores a BIOS (basic input/output system). The power source 29 comprises a power switch SW. When the power switch SW is set in an ON state, the power source circuit 29 applies the operation voltage VO to each circuit in the system.

Operations of the memory chip having the arrangement in Fig. 1 and of a data processing system shown in Fig. 2 will be described below on the basis of different operating states of the power source switch SW in Fig. 5A.

(1) Power Switch SW in ON State

When the power switch SW is set in an ON state, the power source circuit 29 applies the operation voltage VO to each circuit set in the system. The controller 18 is in an system operation state, as shown in Fig. 5C.

The memory controller 23 is controlled by the CPU 22 to control the main memory 30.

More specifically, when data is to be written in the main memory 30, the memory controller 23 supplies write data, a row address, a column address, an RAS, a CAS, a WE at generally known timings. The controller 18 controls the input data multiplexer 9 and the input data buffer 6 to supply the write data to the input/output controller 4 in response to the RAS, the CAS, and the WE. The controller 18 controls the address multiplexer 8 to set row and column addresses in the row and column decoders 2 and 3, respectively. The decoders 2 and 3 decode the latched addresses and set memory cells assigned by the write address to be a selection state. Thus, write data is written in an address of the memory cell array 5 assigned by the write address.

When data is to be read out from the main memory 30, the memory controller 23 supplies a row address, a column address, an RAS, a CAS, and an OE to the main memory 30 at generally known timings. The controller 18 controls the address multiplexer 8 to set addresses in the decoders 2 and 3 in response to the RAS, the CAS, and the OE. Thus, data is read out from an address of the memory cell array 5 assigned by the read address and is output through the input/output controller 4. The controller 18 controls the output multiplexer 10 and the output data buffer 7 to supply the read data output from the input/output controller 4 to the memory controller 23 through the data terminal TD.

As shown in Fig. 5B, the memory controller 23 supplies an RAS signal to the memory chip every interval of 15 $\mu$s to instruct the memory cell array 5 to be refreshed. In response to the RAS signal, the controller 18 controls the address generator 11 to generate a row address sequentially. The controller 18 controls the address multiplexer 8 to set this row address in the row decoder 2 sequentially. By this operation, the memory data in the memory cell array 5 is automatically refreshed.

A resume function of the data processing system in Fig. 2 is set by a setup program or the like. When the resume function is in an ON state, a flag indicating that the resume function is set in ON state is set in a predetermined area of the RTC 27. In addition, a memory clear mode can be selected in place of a memory test mode by the setup program. When the memory clear mode is selected, a flag indicating that the memory clear mode is selected is set in a predetermined area of the RTC 27.

(2) Turn-OFF Operation of Power Source

When the power source switch is turned off, the power source circuit 29 informs the CPU 22 through the bus 21 that the power switch SW is turned off. the CPU 22 checks a memory in the RTC 27 to check whether a resume mode is set or not.

When the resume mode is not set, the CPU 22 outputs an instruction that the output of the operation voltage VO is to be stopped to the power source circuit 29. In response to the instruction, the power source circuit 29 stops applying the operation voltage VO and the buck-up voltage VB to each circuit.

When the resume mode is set, the CPU 22 saves data such as various registers or pointers of the CPU 22 in a memory in the RTC 27. In addition, the CPU 22 outputs an instruction for requiring a check-sum of the data currently stored in the memory cell array 5 to the memory controller 23. In response to this instruction, the memory controller 23 outputs, e.g., WE and OE signals. In response to both the signals, the address generator 11 is controlled by the controller 18 to generate addresses sequentially. These addresses are supplied to the decoders 2 and 3 through the address multiplexer 8 and the address buffer 1 to drive a row and a column of the memory cell array 5. The address generator 11 repeats the above operation while the addresses are updated to read out all data from the memory cell array 5 every interval of 90 $\mu$s.

The readout data is supplied to the check-sum generator 14. The check-sum generator 14 is controlled by the controller 18 to generate a check-sum of the readout data, i.e., all the data stored in the memory cell array 5. The controller 18 sets the obtained check-sum in the check-sum register 15.

Thereafter, the CPU 22 outputs an instruction that an output of the operation voltage VO is to be stopped to the power source circuit 29. In response to this instruction, the power source circuit 29 stops the output of the operation voltage VO. The power source circuit 29 continuously outputs the backup voltage VB to the memory controller 23 and the main memory 30.

## (3) Power Source Switch SW in OFF State

Since the operation voltage VO is not output, as shown in Fig. 5B, the memory controller 23 supplies the RAS signal to the main memory 30 every interval of 90 $\mu$s. In response to the RAS signal, the controller 18 refreshes the memory cell array 5 as in the refreshing in the ON time.

## (4) Turn-ON Operation of Power Source Switch SW

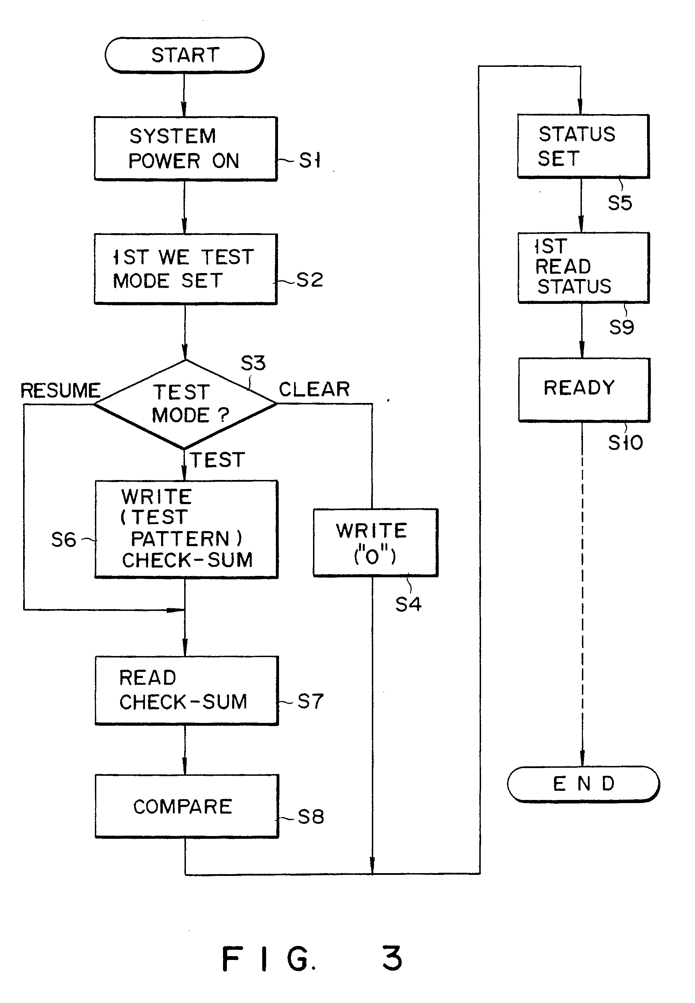

An operation of the system upon turn-ON operation of the power source switch will be described below with reference to the flow chart in Fig. 3.

When the power source switch SW is turned on (step 1), the power source circuit 29 outputs the operation voltage VO. The memory controller 23 changes the refresh interval of the RSA signal into 15 $\mu$s by the operation voltage VO. The controller 18 detects that the refresh interval has been changed, and changes the backup operation into a system operation.

In response to the operation voltage VO, the operation of the CPU 22 is started in accordance with an initialization program stored in the BIOSROM 28. In the step of executing the initialization program, the CPU 22 checks the RTC 27 to check whether a resume mode is set or not. When the resume mode is set, the CPU 22 shifts data stored in the RTC 27 to the original position.

In order to test the main memory 30, the CPU 22 outputs mode data for setting a mode of a memory and a write instruction to the memory controller 23. The CPU 22 can execute a process other than the test for the main memory. In this embodiment, three types of test modes, i.e., a memory clear mode, a memory test mode, and a resume test mode are prepared. When the resume mode is set, the CPU 22 outputs mode data for designating the resume test mode. When the memory clear mode is designated by a setup program, the CPU 22 outputs mode data indicating the memory clear mode. In other cases, the CPU 22 outputs mode data indicating the memory test mode.

In response to a write instruction from the CPU 22, the memory controller 23 supplies a WE signal and the above mode data to the main memory 30 as shown in Figs. 6B and 6C.

In response to the first WE signal in the system operation, the controller 18 supplies a low-level signal (Fig. 6D) to select normal data to the input data multiplexer 9 and outputs an enable signal (Fig. 6E) to the input data buffer 6. Thereby test mode data supplied from the CPU 22 is supplied to the test mode select register 12. The controller 18 supplies a latch signal shown in Fig. 6F to the mode select register 12 and writes test mode data in the register 12 (step S2).

The controller 18 loads the content of the mode selector register 12 to check the test mode (step S3). An operation of the memory chip in each test mode will be described below.

### (i) Memory Test Represented by Mode Data

The controller 18 supplies a test address select signal shown in Fig. 6G and a test address clock shown in Fig. 6H to the address generator 11. The address generator 11 sequentially generates row and column addresses. A test address select signal in Fig. 6G is also supplied to the address multiplexer 8. The address multiplexer 8 responds to the test address select signal, selects addresses generated by the address generator 11, and supplies them to the address buffer 1. The decoders 2 and 3 decode the addresses supplied from the address generator 11 through the address multiplexer 8 and the address buffer 1 and select a row and a column of the memory cell array 5.

The controller 18 supplies a signal indicating an instruction for generating test pattern data and a test pattern clock shown in Fig. 6H to the test data generator 13. In response to these signals, the data generator 13 generates test pattern data. The controller 18 is substantially synchronized with the start of the test pattern data generation to switch the test data select signal to high level, as shown in Fig. 6D. As shown in Fig. 6E, the controller 18 supplies the high-level enable signal to the input data buffer 6. For this reason, the test pattern data generated by the test data generator 13 is supplied to the input/output controller 4 through the input data multiplexer 9 and the input data buffer 6. Thereby, the test pattern data is written in addresses of the memory cell array 5 designated by the address generator 11. The above operation is repeated in response to the clock signals in Figs. 6H and 6I to write the test pattern data at all addresses of the memory cell array 5 (step S6). The test pattern data may be, for example, the data equal to the address data and a plurality of fixed data items.

The test pattern data may be, for example, the data equal to the address data and a plurality The test pattern data is also supplied to the check-sum generator 14. A check-sum start signal shown in Fig. 6J is supplied to the check-sum generator 14 in almost synchronism with the start of the test pattern data generation. In response to this signal, the check-sum generator 14 generates a check-sum of the test pattern data.

When writing of the test pattern data in the memory cell array 5 is ended, the controller 18 supplies a latch signal shown in Fig. 6K to the check-sum register 15. In response to the latch signal, the check-sum register 15 sets the check-sum of test pattern data generated by the check-sum generator 14 (step S6).

With the above operation, a write cycle for a test cycle is finished, and a read cycle is started.

The controller 18 supplies a test address clock signal shown in Fig. 6H and a signal indicating an instruction for generating read addresses to the address generator 11. The address generator 11 sequentially updates and generates the read addresses. The test pattern data is sequentially read out from the memory cell array 5 by the read address (step S7). The readout data is supplied to the check-sum generator 14. The controller 18 supplies a check-sum start signal shown in Fig. 6J to the check-sum generator 14. In response to the start signal, the check-sum generator 14 generates a check-sum of this readout data (step S7).

When reading of data from the memory cell array 5 is ended, the check-sum in read access and the check-sum in the write access set in the check-sum register 15 are compared with each other by the comparator 16 (step S8). The controller 18 outputs a latch signal to the status register 17. In response to the latch signal, the status register 17 sets the comparison result of the comparator 16 and an end flag. With the above process, the read cycle is finished.

(ii) Memory Clear Represented by Mode Data

In this case, an operation of the controller 18 is basically and substantially the same as that of the write cycle in Figs. 6A to 6N. The operation will be briefly described below.

The controller 18 causes the address generator 11 to generate row and column addresses for a test. These addresses are set in row and column decoders 2 and 3 through the address buffer 1, and both the decoders 2 and 3 decode the supplied addresses to select the row and column of the memory cell control array 5.

The controller 18 causes the data test generator 13 to generate all data "0". The all data "0" is supplied to the memory cell array 5 through the input data multiplexer 9 and the input data buffer 6. Data "0" is written in the memory cell array 5 designated by the address generator 11. The controller 18 repeats the above operation while the addresses are updated. Thus, the all data "0" is written at all addresses of the memory cell array 5 (step S4).

When writing of the all data "0" in the memory cell array 5 is ended, the controller 18 sets an end flag in the status register 17 (step S5). Thus, the memory clear mode is finished.

(iii) Resume Test Represented by Mode Data

In this case, an operation of the controller 18 is basically and substantially the same as that of the read cycle in Figs. 6A to 6N, and the operation will be briefly described below.

The controller 18 reads out data stored in the memory cell array 5 in the same manner as that of step S7 to calculate a check-sum. The obtained check-sum and the check-sum which is generated before the power source switch SW is turned off and which is stored in the check-sum register 15 are compared with each other by the comparator 16 (step S8). The comparison result of the comparator 16 and the end flag are set in the register 17. Thus, the resume test is finished.

After the end flag is set in the status resister 17, in the first read cycle, the controller 18 supplies a status data select signal shown in Fig. 6M to the output data multiplexer 10 in response to an OE signal and supplies an enable signal shown in Fig. 6N to the output data buffer 7. By these signals, the content of the status register 17 is output to the memory controller 23 through the output data multiplexer 10, the output buffer 7, and the data terminal TD (step S9).

Thereafter, the mode of the main memory is changed from the test state to the normal state (ready state) (step S10).

As shown in Fig. 6C, the CPU 22 receives the result of the status data through the memory controller 23 and performs the sequential data processing in accordance with the test result. For example, when it is determined that the memory is normal and when memory clear is finished, the CPU 22 continuously performs data processing. When a resume error is detected, the CPU 22 causes the display unit 33 to display the instruction that the resume error is detected. The CPU 22 waits for an operator's instruction and performs a normal test for the main memory 30. When a memory error is detected in this normal memory test, the CPU 22 determines that the main memory 30 has failed, and the CPU 22 causes the display unit 33 to display this.

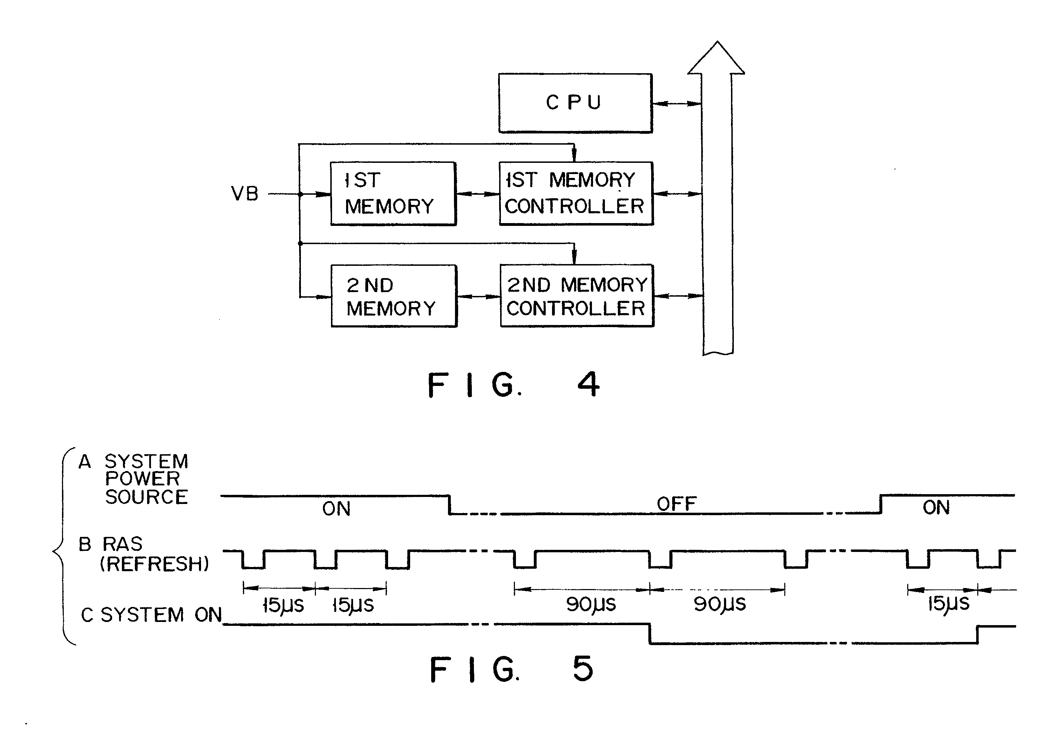

As described above, according to the present invention, a memory LSI can automatically perform a memory test by itself. For this reason, the memory test can be performed within a short time compared with a conventional technique in which a CPU performs the memory test. In addition, since the CPU can perform other processes during the memory test, an operation for a rise time of a computer system can be performed at a high speed. As shown in Fig. 4, even when many memory LSIs are used, the memory tests can be parallelly performed. Therefore, the test for the memory LSI can be performed within a short time.

The present invention is not limited to the above embodiment. For example, in the above embodiment, although three test modes are used, only one or two test modes may be used. A mode except for the above described modes may be used. After a memory test is performed, memory clear may be performed.

In the above embodiment, although the memory test is performed for the entire area of the memory cell array 5, only a part of the area of the memory cell array 5 may be tested. A position and a size for the test can be arbitrarily controlled by addresses generated by the address generator 11.

In the above embodiment, although a method using a check-sum is used as a memory check method, other methods may be used. In the above embodiment, although a check-sum of all data stored in the memory cell array 5 is calculated, check-sums of the data stored in the memory cell array 5 may be calculated every byte or block of the data.

A test pattern generated by the data generator 13 is not limited to one type. For example, in order to accurately check the failure of the memory cell array 5, specific test data is written in the entire area of the memory cell array 5, and the memory cell array 5 is checked. Thereafter, test data which are different from each other at different addresses are written in the entire area of the memory cell array 5, and the memory cell array 5 may be checked.

In the above embodiment, although control signals such as an RAS, a CAS, a WE, and an OE are used to control the controller 18, a special-purpose signal for a memory test may be used. For example, the controller 18 may discriminate a backup mode from a normal mode in accordance with a value of a voltage applied from a power source.

The memory cell is not limited to a DRAM cell, and an SRAM cell may be used as the memory cell. When the SRAM cell is used as the memory cell, as is generally known, a chip select signal CS, a write enable signal WE, and an output enable signal OE are used as control signals.

A refresh interval of the memory cell array 5 is not limited to that of the above embodiment, and other intervals may be used.

In the above embodiment, although a memory chip having the arrangement in Fig. 1 is used as a main memory of the system shown in Fig. 2, the memory chip may be used as a memory except for the main memory, e.g., an image memory. An arrangement of the system is not limited to that in Fig. 2.

In the above embodiment, although a case wherein a memory is backed up has been described, the memory need not be backed up. A memory test may be performed when a power is supplied from a power source to the memory.

## Claims

1. A one-chip memory device comprising:
memory means (5) for storing data and instruction;
address buffer means (1) in which an address of said memory means (5) is set;
output buffer means (7) in which data read out from said memory means (5) is set; and
input buffer means (6) in which writing data in said memory means (5) is set;
characterized by further comprising:
test information generating means (11, 13) for generating test information for testing said memory means (5); and
test means for testing said memory means on the basis of the test information generated by said test information generating means (11, 13).

2. A memory device according to claim 1, characterized in that
said test information generating means includes
address generating means (11) for generating addresses of said memory means (5), and
data generating means (13) for generating all- "0" data; and
said test means includes
addressing means (2, 3) for receiving said addresses from said address generating means (11) and for addressing said memory means (5), and
writing means (4) for writing said all- "0" data supplied from said data generating means (13) in locations of said memory means (5) designated by said addressing means (2, 3).

3. A memory device according to claim 1, characterized in that
said test information generating means includes
address generating means (11) for generating addresses of said memory means (5), and
data generating means (13) for generating test data for testing said memory means (5); and
said test means comprises
addressing means (2, 3) for addressing said memory means (5) using said addresses from said address generating means (11),
writing means (4) for writing said test data supplied from said data generating means (13) in locations of said memory means (5) designated by said addressing means,
means (4) for reading the data from the locations of said memory means (5) designated by said addressing means,
control means
(i) for controlling said address generating means (11), said addressing means (2, 3), said data generating means (13), and said writing means (4) to write said test data in said memory means, and
(ii) after writing of said test data is ended, for controlling said address generating means (11), said addressing means (2, 3), and said reading means (4) to read out the test date from said memory means (5), and
checking means (14 - 17) for checking whether said memory means (5) is normal on the basis of the test data read out from said memory means and said test data written in said memory means (5).

4. A memory device according to claim 3, characterized in that said checking means (14 - 17) includes
first means (14) for calculating and holding a check-sum of said test data written in said memory means (5),
second means (14) for calculating a check-sum of data read from said memory means (5), and
means (16) for comparing the check-sum held by said first means with the check-sum calculated by said second means and to output a signal indicating a comparison result.

5. A memory device according to claim 1, characterized in that
said memory means receives an operation power (VO, VB) regardless of ON/OFF of a main power and stores data;
said test information generating means is constituted by address generating means (11) for generating addresses of said memory means (5); and
said test means comprises
means (1 - 4) for addressing said memory means (5) using said addresses generated by said address generating means (11) and for reading out the data from said memory means (5),
control means
(i) for controlling said address generating means (11) and said addressing means (2, 3) before application of said main power is stopped to read out the memory data from said memory means,
(ii) for controlling said address generating means (11) and said addressing means (2, 3, 4) to read out data from said memory means (5) after said main power (VO) is applied, and
checking means (16, 17) for outputting a signal indicating whether said memory means (5) is normal on the basis of the data read out from said memory means (5) before the application of said main power is stopped and the data read out from said memory means (5) after said main power is applied.

6. A memory device according to claim 5, characterized in that said checking means includes first check-sum means (14) for calculating a check-sum of said data read from said memory means (5) before the application of said main power (VO) is stopped, second check-sum means (14) calculating a check-sum of the data read out from said memory means (5) after said main power is applied, and means (16, 17) for comparing the check-sums calculated by said first and second check-sum means (14) with each other and outputting a signal indicating a comparison result.

7. A memory device according to claim 1, characterized in that said test means (1 - 4, 6 - 17) has a plurality of operation modes and is operated in response to external mode data in accordance with one of said plurality of operation modes.

8. A data processing system comprising power source means (SW) for designating an ON/OFF state of a main power and processing means for processing data in accordance with the ON/OFF state of said main power source, characterized by further comprising:
memory means (30), having a self-testing function, for storing data and instruction, said memory means including memory cell means (5) for storing the data and test means (1 - 4, 6 - 17), connected to said memory cell means (5), for testing said memory cell means (5) and for outputting a test result; and

wherein said processing means (22) processes data using said memory means (22) in an ON state of said main power, when said main power is turned on, supplies an instruction to said test means to perform a test for said memory cell means, receives a test result after the test executed by said test means is ended, checks whether said memory means is normal, and performs data processing on the basis of a check result.

9. A data processing system according to claim 8, characterized in that said test means (1 - 4, 6 - 17) includes at least one of

clear means for clearing data held by said memory cell means when said main power is turned on, and means for writing predetermined test data in said memory cell means (5) when said main power is turned on, for reading out the test data of said memory cell means (5) after writing of the test data is ended, and for outputting a signal indicating whether said memory cell means (5) is normal or abnormal on the basis of the written data and the readout data.

10. A data processing system according to claim 8, characterized in that an operation power is applied to said memory cell means regardless of ON/OFF of the main power; and

said test means includes

(i) means (1 - 4, 11, 18) for reading out the memory data of said memory cell means (5) before application of said main power is stopped,

(ii) means (1 - 4, 11, 18) for reading out the memory data from said memory cell means (5) after said main power is applied, and

(iii) checking means (16, 17) for outputting a signal indicating whether said memory cell means (5) is normal on the basis of the data read out from said memory cell means (5) before the application of said main power is stopped and the data read out from said memory cell means (5) after said main power is applied.

11. A data processing system according to claim 10, characterized in that said checking means includes

first check-sum means (14) for calculating a check-sum of the data read out from said memory cell means (5) before the application of said main power is stopped,

second check-sum means (14) for calculating a check-sum of the data read out from said memory cell means (5) after said main power is applied, and

means (16, 17) for comparing the check-sums calculated by said first and second check-sum means (14) and for outputting a signal indicating a comparison result.

12. A data processing system according to claim 8, characterized in that

said test means has a plurality of operation modes, said calculate processing means outputs mode data for specifying a type of test, and

said test means executes the test in response to said mode data in accordance with one of said plurality of operation modes.

13. A data processing system according to claim 12, characterized in that said plurality of modes have at least two modes selected from:

a first mode for clearing the data held by said memory cell means (5);

a second mode for writing predetermined test data in said memory cell means (5), reading out the memory data of said memory cell means (5) after writing of the predetermined test data is ended, and outputting a signal indicating whether said memory cell means (5) is normal on the basis of the written data and the readout data; and

a third mode for reading out a content of the memory cell means (5) and outputting a signal indicating whether said memory cell means (5) is normal or abnormal on the basis of the previous readout data and the latest readout data.

FIG. 1

ONE-CHIP LSI 30

EP 0 424 911 A2

F I G.   2

F I G. 3

F I G. 4

F I G. 5

FIG. 6

EP 0 424 911 A2